# EUROPEAN PATENT APPLICATION

(11) **EP 0 651 446 A2**
(43) Date of publication of application: **03.05.1995**
(21) Application number: 94116263.8
(22) Date of filing: 14.10.1994
(51) Int. Cl.: H01L 29/74, H01L 29/10, H01L 29/36

(54) **GTO thyristor**

(30) Priority: 28.10.1993 JP 270646/93
(71) Applicant: KABUSHIKI KAISHA TOSHIBA, Kawasaki-shi, Kanagawa-ken 210 (JP)
(72) Inventor: Hiyoshi, Michiaki, c/o Intellectual Property Div., Minato-ku, Tokyo 105 (JP); Fujiwara,Takashi c/o Intellectual Property Div., Minato-ku Tokyo 105 (JP); Matsuda Hideo, c/o Intellectual Property Div., Minato-ku Tokyo 105 (JP)
(74) Representative: Lehn, Werner, Dipl.-Ing.

(57) **Abstract**

Protons (23) are ion-implanted into that region (22) of an N⁻-type base layer (16) of a silicon substrate (13) which is not depleted when a peak voltage V_{DM} is applied to a thyristor in order to turn off the thyristor, at an incident angle of 0°, using an amorphous aluminum absorber, with the result that an effective defect region (24) is formed in the N⁻-type base layer. The effective defect region (24) is formed throughout the region of the N⁻-type base layer (16), which is not depleted. The carrier lifetime of the entire silicon substrate (13) is shortened by electron beam irradiation.

## Description

The present invention relates to a GTO thyristor and, more particularly, to a GTO thyristor capable of shortening turnoff time.

In a conventional power device such as a high withstanding-voltage GTO thyristor and a reverse blocking GTO thyristor, EBI (Electron Beam Irradiation) has generally been performed in order to control carrier lifetime. The characteristic advantage of the EBI is to uniformly decrease the carrier lifetime of the entire N-type base layer. As another method for controlling the carrier lifetime, ion implantation of, for example, proton and helium has recently been employed. The advantage of the ion implantation is to form a short-lifetime layer locally in an N-type base layer and, in other words, to allow the carrier distribution of an N-type base layer to be locally controlled.

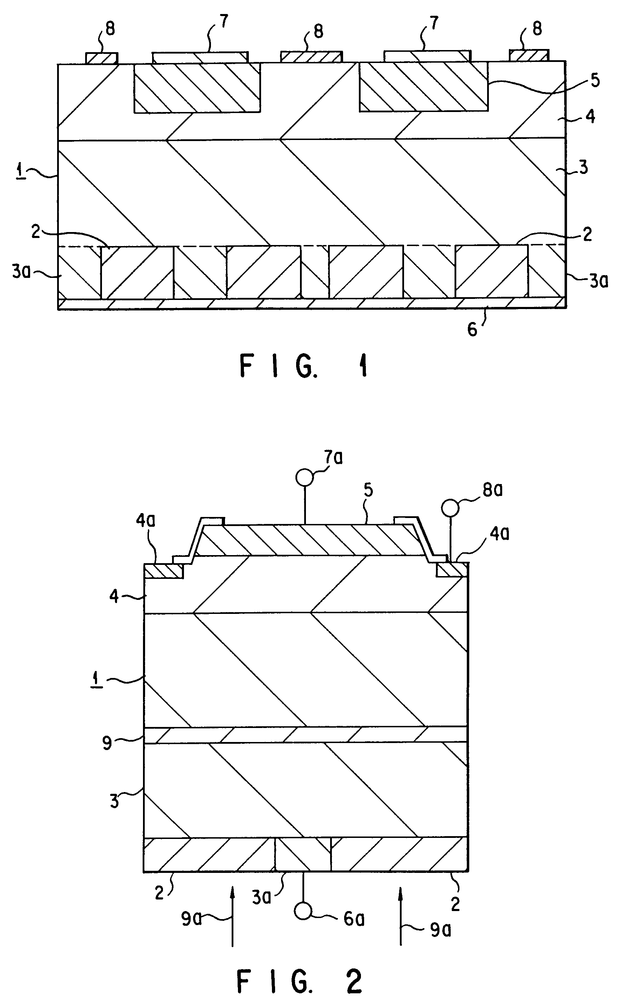

FIG. 1 is a cross-sectional view showing a first conventional shorted anode GTO thyristor. As shown in FIG. 1, a silicon substrate 1 includes a P-type emitter layer 2, an N-type base layer 3, and P-type base layer 4. An N-type emitter layer 5 is formed in the P-type base layer 4, and an N-type anode short-circuiting layer 3a is formed in the P-type emitter layer 2. An anode aluminum electrode 6 is provided on the undersurfaces of the N-type anode short-circuiting layer 3a and P-type emitter layer 2, and an anode aluminum electrode 7 is provided on the N-type emitter layer 5. A gate aluminum electrode 8 is provided on the P-type base layer 4.

The thickness of the N-type base layer 3 is set to several hundreds of micrometers in order to increase a withstanding voltage. The lifetime of the entire N-type base layer 3 is reduced uniformly by irradiating the entire N-type base layer 3 with electron beams.

In the first conventional shorted anode GTO thyristor, a turnoff loss can be lessened since the N-type base layer 3 is increased in thickness and its lifetime is shortened, but an on-state voltage is increased. It is more desirable to decrease the on-state voltage as much as possible in order to reduce a power loss of the thyristor.

The above turnoff loss is represented by a multiplication of tail current Iₜₐᵢₗ and voltage V_{T}. The tail current Iₜₐᵢₗ has only to be reduced to lessen the turnoff loss. The tail current Iₜₐᵢₗ can be reduced by shortening the carrier lifetime of the N-type base layer 3. To shorten the turnoff time, the carrier lifetime has to be shortened. The on-state voltage of the thyristor is controlled by the carriers stored in the N-type base layer 3 and the lifetime thereof. The longer the carrier lifetime of the N-type base layer 3, or the thinner the N-type base layer 3, the lower the on-state voltage. However, the turnoff loss (E_{off}) of the thyristor occurs when the carriers are discharged from the N-type base layer 3, and the number of the carriers depends upon the carrier lifetime of the N-type base layer 3. Therefore, the shorter the lifetime of the N-type base layer 3, the less the turnoff loss. There is a tradeoff relationship between the on-state voltage and turnoff loss. In other words, if the lifetime of the N-type base layer 3 is shortened by the EBI, the turnoff loss decreases, but the on-state voltage increases.

FIG. 2 is a cross-sectional view showing a second conventional shorted anode GTO thyristor. In FIG. 2, the same structural elements as those in FIG. 1 are denoted by the same reference numerals.

An N⁻-type base layer 3 is formed on a P⁺-type emitter layer 2, and a P-type base layer 4 is formed on the layer 3. An N⁺-type emitter layer 5 is formed on the P-type base layer 4 and electrically connected to a cathode terminal 7a. An N⁺-type anode short-circuiting layer 3a is formed in the P⁺-type emitter layer 2 and electrically connected to an anode terminal 6a. A P⁺-type base layer 4a is formed in the P-type base layer 4 and electrically connected to a gate terminal 8a.

A considerably thin defective region 9 is formed locally in the middle of the N⁻-type base layer 3 by implanting ions such as protons 9a. The defective region 9 is a short-lifetime layer and located at an end portion of that region alongside the P⁺-type emitter layer 2 which is depleted when half of peak voltage 1/2 V_{DM} is applied to the thyristor in order to turn off the thyristor.

Since, in the second conventional shorted anode GTO thyristor, the thin defective region 9 is formed in the N⁻-type base layer 3, the carrier distribution of the layer 3 is controlled. For this reason, the tradeoff between the on-state voltage and turnoff loss can be improved more greatly than that in the first conventional GTO thyristor. However, the half-width of the defective region 9 is very narrow, and the N⁻-type base layer 3 remains wide even by the above ion-implantation. Since the layer 3 maintains a long lifetime, the on-state voltage can be dropped, but the turnoff loss cannot be reduced sufficiently. Thus, the trade-off cannot be improved sufficiently.

In conclusion, the peak of the tail current Iₜₐᵢₗ can be suppressed if the defective region 9 is formed in the middle of the N⁻-type base layer 3. Since, however, the lifetime of the N⁻-type base layer 3 other than the defective region 9 is long, the attenuation of the tail current Iₜₐᵢₗ is decreased in speed, with the result that the turnoff loss is not reduced. In contrast, if the defective region 9 is formed from the middle of the N⁻-type base layer 3 toward the P⁺-type emitter layer 2, the attenuation of the tail current Iₜₐᵢₗ can be quickened, but the peak of the tail current cannot be suppressed. Consequently, the turnoff loss of the thyristor cannot be reduced sufficiently.

An object of the present invention is to provide a GTO thyristor improved in trade-off between an on-state voltage and a turnoff loss.

To attain the above object, there is provided a GTO thyristor comprising:
a P-type emitter layer;
an N-type base layer formed on the P-type emitter layer;
a short-lifetime layer formed widely in a specific region within the N-type base layer;
a P-type base layer formed on the N-type base layer; and
an N-type emitter layer formed on the P-type base layer.

In a GTO thyristor of the present invention, a short-lifetime layer is not formed locally in a specific region within an N-type base layer, unlike the prior art GTO thyristor. The short-lifetime layer of the present invention is formed widely therein by ion-implantation of protons or helium. Thus, a tradeoff between the on-state voltage and turnoff loss of the thyristor can be improved and, in particular, the turnoff loss can be reduced.

This invention can be more fully understood from the following detailed description when taken in conjunction with the accompanying drawings, in which:
FIG. 1 is a cross-sectional view showing a first conventional shorted anode GTO thyristor;
FIG. 2 is a cross-sectional view showing a second conventional shorted anode GTO thyristor;
FIG. 3 is a cross-sectional view showing a reverse blocking GTO thyristor according to a first embodiment of the present invention;
FIG. 4 is a graph showing a relationship between the depth of a silicon substrate of the GTO thyristor shown in FIG. 3, to which protons are ion-implanted using an amorphous aluminum absorber, and the defect density of the silicon substrate;
FIG. 5 is a graph showing a relationship in trade-off between on-state voltage V_{TM} and turnoff loss E_{off} in first to third shorted anode GTO thyristors;
FIG. 6 is a graph showing a relationship in trade-off between on-state voltage V_{TM} and turnoff loss E_{off} in first and second reverse blocking GTO thyristors;
FIG. 7 is a graph showing a turnoff waveform of a shorted anode GTO thyristor according to a second embodiment of the present invention;
FIG. 8 is a graph showing a turnoff waveform of the shorted anode GTO thyristor of FIG. 7 using only the ion-implantation of protons, a turnoff waveform of a shorted anode GTO thyristor in which the carrier lifetime of the entire silicon substrate is shortened by only the EBI, and a turnoff waveform of a shorted anode GTO thyristor using both the ion-implantation and EBI;
FIG. 9 is a cross-sectional view showing a shorted anode GTO thyristor according to a third embodiment of the present invention;
FIG. 10 is a graph showing a turnoff waveform of the shorted anode GTO thyristor of FIG. 9;
FIG. 11 is a cross-sectional view showing a shorted anode GTO thyristor according to a fourth embodiment of the present invention;
FIG. 12 is a graph showing a relationship between the depth of a silicon substrate of the GTO thyristor shown in FIG. 11, to which protons are ion-implanted using a crystalline aluminum absorber, and the defect density of the silicon substrate;
FIG. 13 is a graph showing a relationship in trade-off between on-state voltage V_{TM} and turnoff loss E_{off} in first to fourth shorted anode GTO thyristors; and
FIG. 14 is a graph showing a relationship in trade-off between on-state voltage V_{TM} and switching time tₛ in the first to fourth shorted anode GTO thyristors.

Embodiments of the present invention will now be described, with reference to the accompanying drawings.

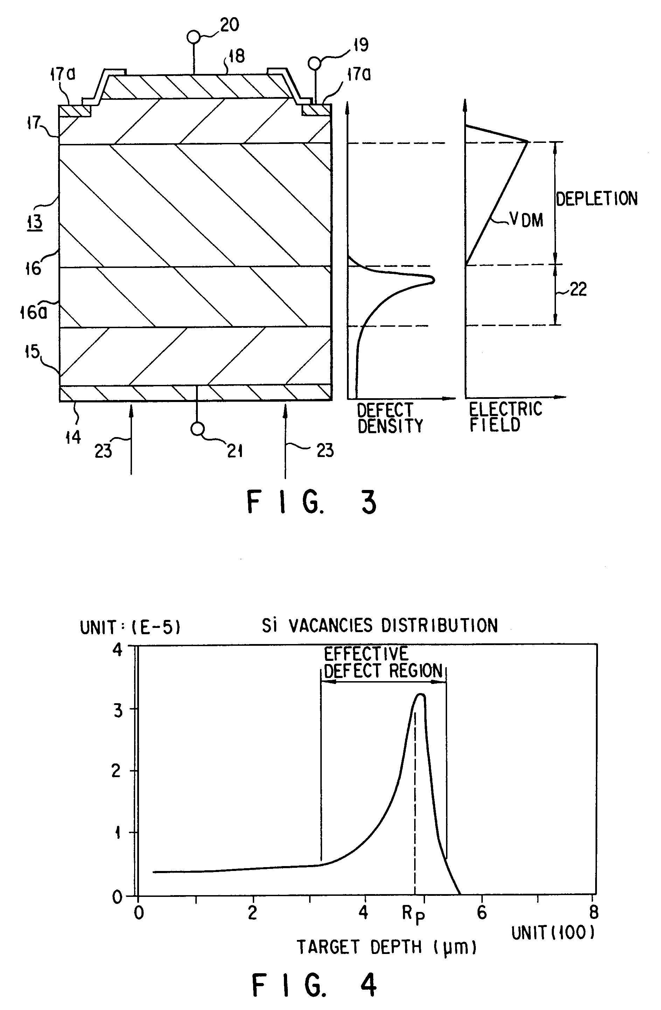

FIG. 3 is a cross-sectional view showing a reverse blocking GTO thyristor according to a first embodiment of the present invention, and FIG. 4 is a graph showing a relationship between that depth of a silicon substrate of the GTO thyristor shown in FIG. 3, to which protons are ion-implanted using an amorphous aluminum absorber, and the defect density of the silicon substrate.

As illustrated in FIG. 3, a silicon substrate 13 includes a P⁺-type layer 14, a P-type emitter layer 15, an N⁻-type base layer 16, and a P-type base layer 17. An N⁺-type emitter layer 18 is formed on the P-type base layer 17. A P⁺-type base layer 17a is formed in the P-type base layer 17 and electrically connected to a gate terminal 19. The N⁺-type emitter layer 18 is electrically connected to a cathode terminal 20. The P⁺-type layer 14 is electrically connected to an anode terminal 21.

Protons 23 are ion-implanted into that region 22 of the N⁻-type base layer 16 which is not depleted when a peak voltage V_{DM} is applied to the thyristor in order to turn off the GTO thyristor, at an incident angle of 0°, using an amorphous aluminum absorber (not shown), with the result that an effective defect region 16a is formed in the N⁻-type base layer 16. More specifically, the protons are accelerated at high energy, dispersed in the amorphous aluminum absorber, and ion-implanted into the silicon substrate 13. If such an amorphous absorber is employed, the thickness of the effective defect region 16a is increased more greatly than when ions are implanted directly into the silicon substrate 13. The carrier lifetime of the effective defect region 16a is very short, and the thickness thereof is about 220 µm. Further, the effective defect region 16a is formed throughout the region 22 which is not depleted in the N⁻-type base region 16.

EBI (Electron Beam Irradiation) is then applied to the GTO thyristor thereby to shorten the carrier lifetime of the entire silicon substrate 13. In this case, the carrier lifetime of the effective defect region 16a is shorter than that of the other regions of the silicon substrate 13.

According to the foregoing first embodiment of the present invention, when the protons 23 are ion-implanted into the silicon substrate 13 using the amorphous aluminum absorber, the effective defect region is enlarged, and its thickness is about 220 µm, as shown in FIG. 4. In other words, the effective defect region 16a of about 220 µm is formed in the N⁻-type base layer 16 alongside the P-type emitter layer 15, and corresponds to the region 22 which is not depleted even when the peak voltage V_{DM} is applied to the thyristor in order to turn off the thyristor. If this region 22 is completely covered with the effective defect region 16a, its carriers can be eliminated quickly, with the result that the turnoff loss of the thyristor can be reduced and the turnoff time thereof can be shortened.

Since the carrier lifetime of the entire silicon substrate 13 is shortened by the EBI, the number of carriers discharged from the N⁻-type base layer 16 can be decreased when the thyristor is turned off. As a result, the switching time tₛ of the thyristor can be shortened and the tail current can be reduced.

In the first embodiment, the effective defect region 16a is formed by ion-implantation of the protons 23. However, it can be formed by ion-implantation of helium. Furthermore, in the first embodiment, the protons 23 are ion-implanted into the region 22 using the amorphous aluminum absorber. However, another amorphous absorber can be used to ion-implant the protons 23 into the region 22.

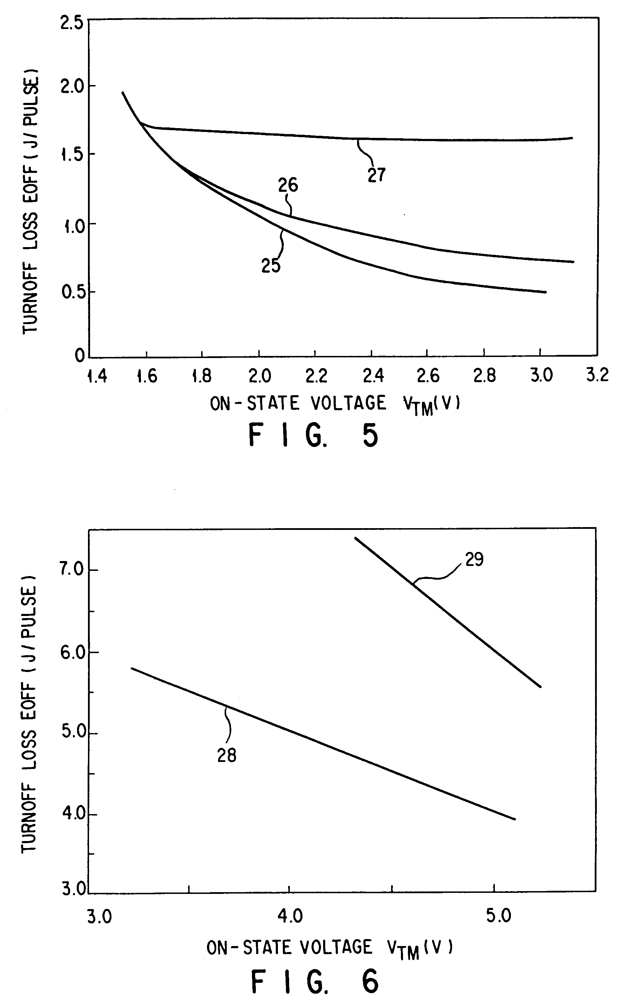

FIG. 5 is a graph showing a relationship in trade-off between on-state voltage V_{TM} and turnoff loss E_{off} in first to third shorted anode GTO thyristors. In FIG. 5, curves 25 to 27 denote the first to third GTO thyristors, respectively.

The first shorted anode GTO thyristor 25 has a defect region formed by ion-implantation of helium at the same position as that of the effective defect region of the GTO thyristor of the first embodiment. In this GTO thyristor, the carrier lifetime of the whole silicon substrate is shortened by EBI.

In the second shorted anode GTO thyristor 26, the carrier lifetime of the whole silicon substrate is shortened only by the EBI.

The third shorted anode GTO thyristor 27 has a defect region formed only by ion-implantation of helium at the same position as that of the effective defect region of the GTO thyristor of the first embodiment.

It is apparent from the curve 27 representing the third GTO thyristor that, if the dosage of helium is increased only by the ion-implantation, the turnoff loss is stopped to decrease at once, while the on-state voltage is increased. If, therefore, the dosage of helium is suppressed to about 1 × 10¹⁰ cm⁻² which is smaller than the dosage by which the decrease of the turnoff loss is stopped, and the EBI is added further, then the turnoff loss is improved about 30% when the on-state voltage is 2.5V or more, as indicated by the curve 25 representing the first shorted anode GTO thyristor, compared with the second shorted anode GTO thyristor 26 using the EBI only.

FIG. 6 is a graph showing a relationship in trade-off between on-state voltage V_{TM} and turnoff loss E_{off} in first and second reverse blocking GTO thyristors. In FIG. 6, lines 28 and 29 indicate the first and second GTO thyristors, respectively.

The first reverse blocking GTO thyristor 28 has a defect region formed only by ion-implantation of protons at the same position as that of the effective defect region of the GTO thyristor according to the first embodiment.

In the second reverse blocking GTO thyristor 29, the carrier lifetime of the entire silicon substrate is shortened only by the EBI.

As is apparent from FIG. 6, the turnoff loss of the first reverse blocking GTO thyristor in which the defect region is formed only by ion-implantation of protons, can be improved about 40%, as compared with that of the second reverse blocking GTO thyristor in which the defect region is formed only by the EBI.

A shorted anode GTO thyristor according to a second embodiment of the present invention will now be described. The descriptions of the same structural elements as those of the first embodiment are omitted.

The GTO thyristor of the second embodiment has an effective defect region formed by ion-implantation of protons or the like at the same position as that of the GTO thyristor of the first embodiment. No EBI is applied to this GTO thyristor.

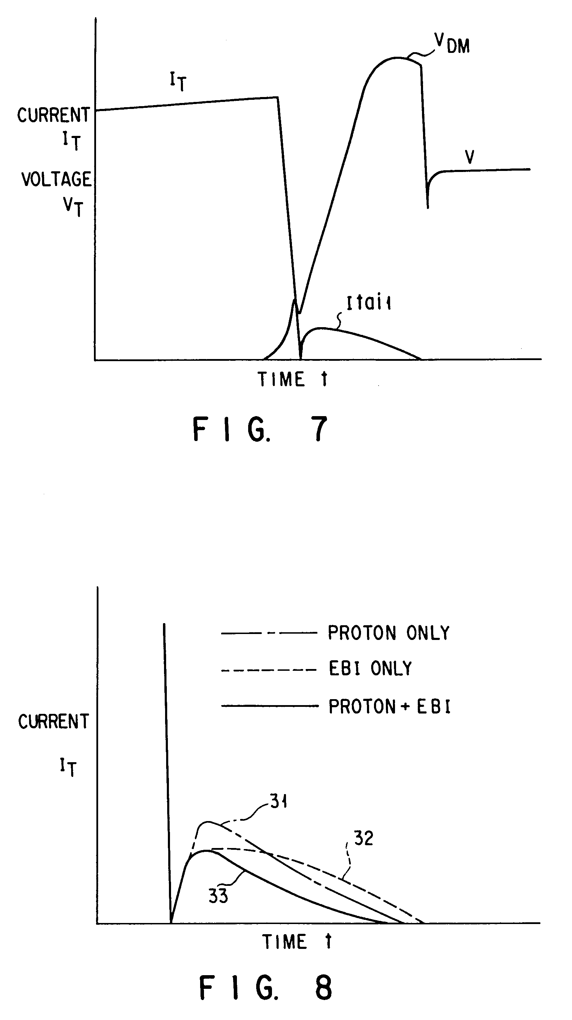

FIG. 7 is a graph showing a turnoff waveform of the shorted anode GTO thyristor according to the second embodiment of the present invention. FIG. 8 is a graph showing a turnoff waveform of the shorted anode GTO thyristor of FIG. 7 using only the ion-implantation of protons, a turnoff waveform of a shorted anode GTO thyristor in which the carrier lifetime of the entire silicon substrate is shortened by only the EBI, and a turnoff waveform of a shorted anode GTO thyristor using both the ion-implantation and EBI.

As shown in FIG. 8, in the shorted anode GTO thyristor of the second embodiment, indicated by curve 31, the speed of the attenuation of tail current Iₜₐᵢₗ is high, but the peak of the tail current is increased since the carrier lifetime in the vicinity of the main junction between the N⁻-type base layer 16 and P-type base layer 17 shown in FIG. 3 is long. In the shorted anode GTO thyristor indicated by curve 32, the peak of the tail current Iₜₐᵢₗ is decreased, but the attenuations thereof is delayed. It is thus the shorted anode GTO thyristor, indicated by curve 33, that is able to both reduce the peak of the tail current and increase the attenuation thereof. Consequently, the turnoff loss of the shorted anode GTO thyristor can be decreased by using both the ion-implantation of protons and the EBI.

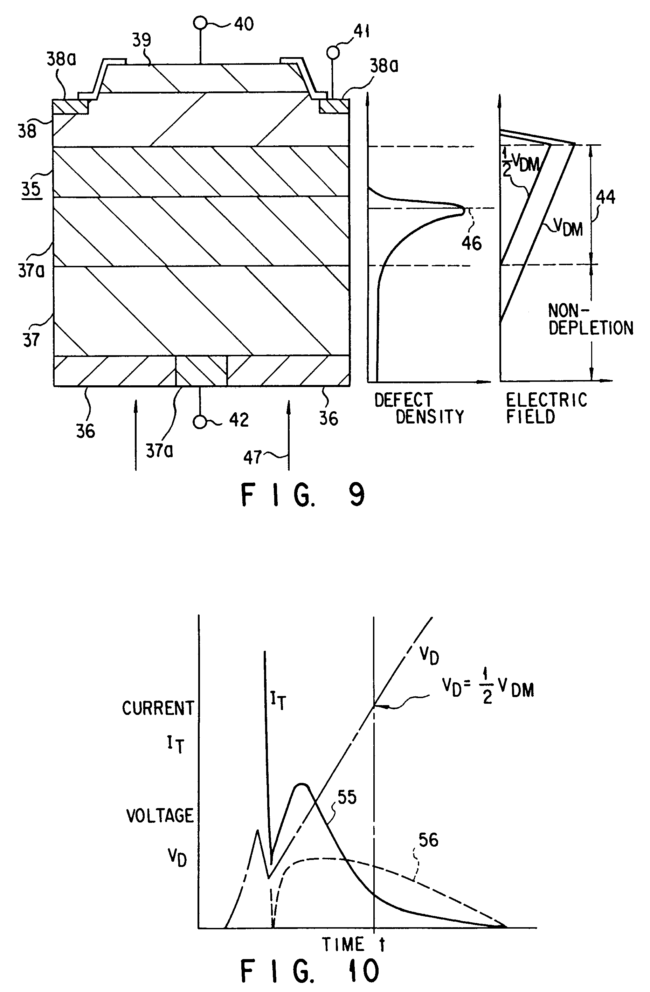

FIG. 9 is a cross-sectional view showing a shorted anode GTO thyristor according to a third embodiment of the present invention.

Referring to FIG. 9, a silicon substrate 35 includes a P⁺-type emitter layer 36, an N⁻-type base layer 37, and a P-type base layer 38. An N⁺-type emitter layer 39 is formed on the P-type base layer 38 and electrically connected to a cathode terminal 40. A P⁺-type base layer 38a is formed in the P-type base layer 38 and electrically connected to a gate terminal 41. An N⁺-type anode short-circuiting layer 37a is formed in the P⁺-type emitter layer 36 and electrically connected to an anode terminal 42.

Protons 47 are ion-implanted into the N⁻-type base layer 37 of the silicon substrate 35, using an amorphous aluminum absorber. The protons are implanted in such a manner that the peak of the protons is located at a position 46 near the middle of a depleted region 44 to be formed in the N⁻-type base layer 37 when half of the peak voltage 1/2 V_{DM} is applied to the thyristor in order to turn off the thyristor. Thus, an effective defect region 37a is formed in the N⁻-type base layer 37 from one end of the depleted region 44 toward the position 46. This effective defect region 37a is a layer of a very short carrier lifetime, and its thickness is about 220 µm.

The effective defect region 37a is formed by ion-implanting the protons 47 into the silicon substrate 35 using the amorphous aluminum absorber and, in other words, the region 37a is formed in the depleted region 44 of the N⁻-type base layer 37 and alongside the P⁺-type emitter layer 36. Therefore, the turnoff loss of the thyristor can be reduced.

In the third embodiment, the effective defect region 37a is formed by ion-implantation of the protons 47. However, it can be formed by ion-implantation of helium.

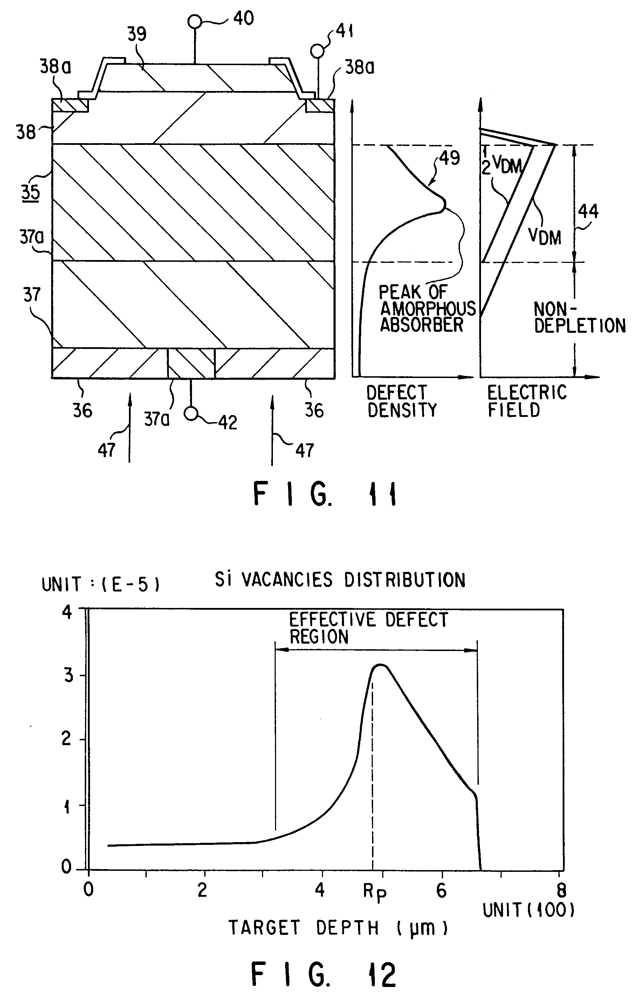

FIG. 10 shows a turnoff waveform of the shorted anode GTO thyristor of the third embodiment. More specifically, FIG. 10 shows a turnoff waveform 55 of the shorted anode GTO thyristor of the third embodiment and a turnoff waveform 56 of a shorted anode GTO thyristor wherein the carrier lifetime of the entire silicon substrate is shortened by only the EBI.

As is apparent from FIG. 10, in the shorted anode GTO thyristor having the turnoff waveform 56 using only the EBI, the amount (V × I) of turnoff loss is large since the tail current is increased when a high voltage is applied to the thyristor. However, in the shorted anode GTO thyristor of the third embodiment having the turnoff waveform 55, the amount of turnoff loss is small since the tail current is suppressed when the high voltage is applied to the thyristor.

FIG. 11 is a cross-sectional view showing a shorted anode GTO thyristor according to a fourth embodiment of the present invention. In FIG. 11, the same structural elements as those in FIG. 9 are denoted by the same reference numerals, and their descriptions are omitted. FIG. 12 shows a relationship between the depth of a silicon substrate of the GTO thyristor shown in FIG. 11, to which protons are ion-implanted using a crystalline aluminum absorber, and the defect density of the silicon substrate.

Protons 47 are ion-implanted into an N⁻-type base layer 37 of a silicon substrate 35 at an incident angle of 0° with respect to the channel direction, using, for example, a crystalline silicon absorber (not shown), resulting in channeling and de-channeling 49 to be used. Therefore, an effective defect region 37a is formed throughout a depleted region 44, and its thickness is about 350 µm, as is seen from FIG. 12.

The same advantage as that of the third embodiment can be obtained from the fourth embodiment. Since the protons 47 are ion-implanted into the silicon substrate 35 using the crystalline silicon absorber, the thickness of the effective defect region is larger than using the amorphous aluminum absorber. Since, therefore, the effective defect region 37a can be formed in the entire depleted region 44 of the N⁻-type base layer 37, the turnoff loss can be reduced further.

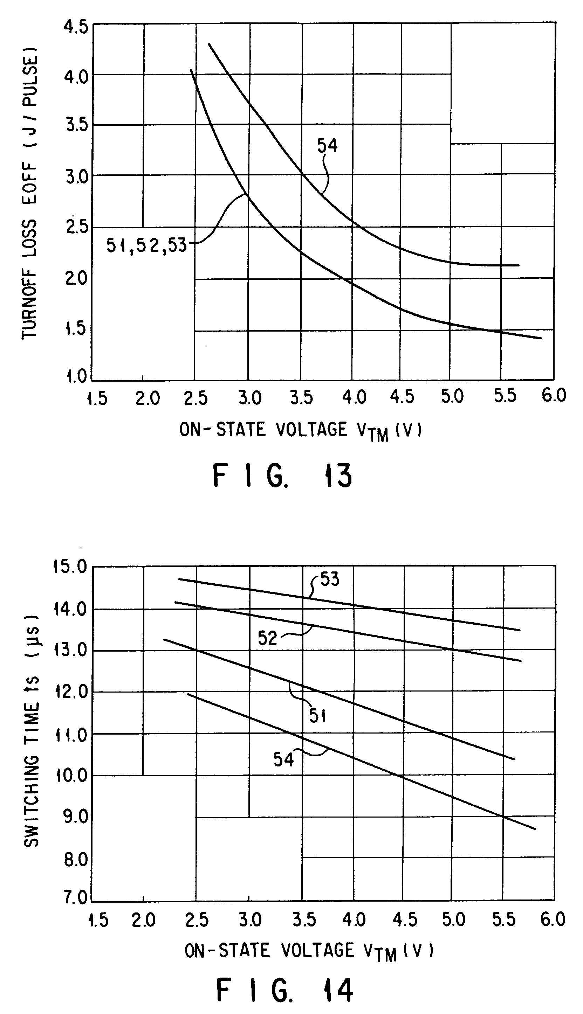

FIG. 13 is a graph showing a relationship in trade-off between on-state voltage V_{TM} and turnoff loss E_{off} in first to fourth shorted anode GTO thyristors 51 to 54.

The first shorted anode GTO thyristor 51 has a defect region which is formed by ion-implantation of protons at the same location as that of the effective defect region of the GTO thyristor according to the third embodiment. Furthermore, in this first GTO thyristor, the carrier lifetime of the whole silicon substrate is shortened by the EBI.

The second shorted anode GTO thyristor 52 has a defect region which is formed by ion-implantation of protons using a silicon absorber at the same location as that of the effective defect region of the GTO thyristor according to the third embodiment.

The third shorted anode GTO thyristor 53 has a defect region which is formed by ion-implantation of protons using an aluminum absorber at the same location as that of the effective defect region of the GTO thyristor according to the third embodiment.

In the fourth shorted anode GTO thyristor 54, the carrier lifetime of the whole silicon substrate is shortened by only the EBI.

As is apparent from FIG. 13, the turnoff loss of each of the first to third shorted anode GTO thyristors 51 to 53 can be decreased about 30%, as compared with the fourth shorted anode GTO thyristor 54.

FIG. 14 is a graph showing a relationship in trade-off between on-state voltage V_{TM} and switching time tₛ in the above first to fourth shorted anode GTO thyristors 51 to 54.

As is seen from FIG. 14, it is the fourth shorted anode GTO thyristor 54 that is the most excellent in the tradeoff, followed by the first GTO thyristor 51, the second GTO thyristor 52, and the third GTO thyristor 53. More specifically, the first shorted anode GTO thyristor 51 using both the ion-implantation of protons and EBI is preferable to the second and third GTO thyristors 52 and 53 using only the ion-implantation of protons. The fourth shorted anode GTO thyristor 54 wherein the carrier lifetime of the entire silicon substrate is shortened by the EBI, is much preferable thereto.

In the first to fourth embodiments, the protons or helium are ion-implanted into the silicon substrate at an incident angle of 0°, using an aluminum or silicon absorber. However, the ion-implantation can be performed at an incident angle of 7° or more, except in the channel direction.

A shorted anode GTO thyristor according to a fifth embodiment of the present invention will be described. This GTO thyristor is the same as that of the third embodiment, except for the following respect. In the fifth embodiment, the EBI is applied to the GTO thyristor.

## Claims

1. A GTO thyristor comprising:
a P-type emitter layer (15, 36);
an N-type base layer (16, 37) formed on said P-type emitter layer (15, 36);
a short carrier lifetime layer (16a, 37a) formed widely in a specific region within said N-type base layer (16, 37);
a P-type base layer (17, 38) formed on said N-type base layer (16, 37); and
an N-type emitter layer (18, 39) formed on said P-type base layer (17, 38).

2. The GTO thyristor according to claim 1, characterized in that said short carrier lifetime layer (16a) is formed throughout a region (22) of said N-type base layer (16), said region (22) being not depleted even when a peak voltage is applied to said GTO thyristor.

3. The GTO thyristor according to claim 1, characterized in that a carrier lifetime of all of said N-type base layer (16) is shortened by electron beam irradiation.

4. The GTO thyristor according to claim 3, characterized in that a carrier lifetime of said short carrier lifetime layer (16a, 37a) is shorter than a carrier lifetime of a region of said N-type base layer (16, 37) excluding said short carrier lifetime layer, and is formed by ion-implanting one of proton (23, 47) and helium.

5. The GTO thyristor according to claim 2, characterized in that said short carrier lifetime layer (16a) has a thickness of about 220 µm.

6. The GTO thyristor according to claim 3, characterized in that said short carrier lifetime layer (16a) is located alongside said P-type emitter layer (15) in said N-type base layer (16).

7. The GTO thyristor according to claim 1, characterized in that said short carrier lifetime layer (37a) is located alongside said P-type emitter layer (36) in a region (44) of said N-type base layer (37), said region (44) being depleted when half of a peak voltage is applied to said GTO thyristor.

8. The GTO thyristor according to claim 7, characterized in that a carrier lifetime of all of said N-type base layer (37) is shortened by electron beam irradiation.

9. The GTO thyristor according to claim 7, characterized in that said short carrier lifetime layer (37a) has a thickness of about 220 µm.

10. The GTO thyristor according to claim 1, characterized in that said short carrier lifetime layer (37a) is formed throughout a region (44) of said N-type base layer (37), said region (44) being depleted when half of a peak voltage is applied to said GTO thyristor.

11. The GTO thyristor according to claim 10, characterized in that said short carrier lifetime layer (37a) has a thickness of about 350 µm.

12. A GTO thyristor comprising:
a P-type emitter layer (15);
an N-type base layer (16) formed on said P-type emitter layer (15), a carrier lifetime of all of said N-type base layer (16) being shortened by electron beam irradiation;
a short carrier lifetime layer (16a) formed widely in said N-type base layer (16), said short carrier lifetime layer (16a) being formed in a region (22), which is not depleted even by applying a peak voltage to said GTO thyristor, by ion-implanting one of proton (23) and helium, and a carrier lifetime of said short carrier lifetime layer (16a) being shorter than a carrier lifetime of a region of said N-type base layer (16) excluding said short carrier lifetime layer (16a);
a P-type base layer (17) formed on said N-type base layer (16); and
an N-type emitter layer (18) formed on said P-type base layer (17).
